# EUROPÄISCHE PATENTSCHRIFT

(11) **EP 4 160 908 B1**
(45) Veröffentlichungstag und Bekanntmachung des Hinweises auf die Patenterteilung: **07.01.2026**
(21) Anmeldenummer: 22195912.5
(22) Anmeldetag: 15.09.2022
(51) Int. Cl.: H02S 40/34

(54) **PHOTOVOLTAIKMODUL UND ANSCHLUSSANORDNUNG FÜR EIN PHOTOVOLTAIKMODUL**
PHOTOVOLTAIC MODULE AND CONNECTION ASSEMBLY FOR A PHOTOVOLTAIC MODULE
MODULE PHOTOVOLTAÏQUE ET ENSEMBLE DE CONNEXION POUR UN MODULE PHOTOVOLTAÏQUE

(30) Priorität: 29.09.2021 DE 102021125242
(43) Veröffentlichungstag der Anmeldung: 05.04.2023
(73) Patentinhaber: Weidmüller Interface GmbH & Co. KG, 32758 Detmold (DE)
(72) Erfinder: BÖNSCH, Matthias, 33659 Bielefeld (DE); WÜNSCHE, Torsten, 33818 Leopoldshöhe (DE); DALLMANN, Niels, 32584 Löhne (DE)
(74) Vertreter: Kleine, Hubertus

(56) Entgegenhaltungen:
- CN-A- 107 612 493
- CN-U- 202 996 867
- DE-A1- 102010 030 478
- DE-A1- 102015 111 768
- DE-A1- 102015 218 526
- US-A1- 2015 053 251
- US-A1- 2015 275 578
- US-A1- 2019 210 539
- US-A1- 2022 359 102

## Beschreibung

Die Erfindung betrifft eine Anschlussanordnung für ein Photovoltaikmodul (PV-Modul), das mindestens eine Zellanordnung aufweist, die extern an mindestens zwei Kontakten kontaktierbar ist. Die Anschlussanordnung umfasst mindestens eine Bypass-Diode, die extern von der mindestens einen Zellanordnung angeordnet ist und parallel zu der mindestens einen Zellanordnung geschaltet ist, wobei die Anschlussanordnung mindestens eine Anschlussdose aufweist und mindestens eine Steckaufnahme, in die die Bypass-Diode mit Steckkontakten eingesteckt ist. Die Erfindung betrifft weiter ein Photovoltaikmodul mit einer derartigen Anschlussanordnung.

PV-Module, z. B. zur Montage auf einem Hausdach oder in Freilandanlagen, weisen in der Regel eine Mehrzahl von Photovoltaikzellen (PV-Zellen) auf, die seriell und/oder parallel verschaltet mindestens eine Zellanordnung bilden, die von extern über Anschlusskabel kontaktierbar ist. Häufig weisen PV-Module mehrere solcher Zellanordnungen auf, die innerhalb des PV-Moduls serienverschaltet sind. **In** dem Fall ist üblicherweise jede der Zellanordnungen mit ihren Endanschlüssen aus dem Modul herausgeführt, um parallel zu jeder Zellanordnung jeweils eine sog. "Bypass-Diode" zu schalten. Die Bypass-Dioden leiten Strom an verschatteten oder defekten Zellanordnungen vorbei. Ohne die Bypass-Dioden würde eine Verschattung oder ein Defekt einer der Zellanordnungen des Moduls den Stromfluss durch das gesamte Modul verringern, auch wenn die anderen Zellanordnungen des Moduls oder auch andere, mit dem Modul in Reihe geschaltete weitere Module, nicht verschattet oder defekt sind.

Aus dem Stand der Technik sind PV-Module bekannt, bei denen Anschlüsse der vorhandenen Zellanordnungen (üblicherweise von drei Zellanordnungen) benachbart zueinander an einer Rückseite des PV-Moduls in einem gemeinsamen Anschlussbereich kontaktierbar sind. Die Kontakte können beispielsweise nicht isolierte Kontaktstreifen auf der ansonsten von einer isolierenden Schicht abgedeckten Rückseite der PV-Module sein. Über den Kontaktbereich wird eine Anschlussdose gesetzt, beispielsweise aufgeklebt, innerhalb der die Bypass-Dioden angeordnet sind und die Kontaktflächen des PV-Moduls kontaktieren. Zudem führen zwei Anschlusskabel zu der genannten Anschlussdose, die mit den äußeren Kontakten der serienverschalteten Zellanordnungen verbunden sind und über die das PV-Modul extern angeschlossen wird.

Ein PV-Modul mit einer derartigen Anschlussanordnung ist beispielsweise in der Druckschrift US 2016/0141435 A1 in einem Ausführungsbeispiel beschrieben. **In** einem weiteren Ausführungsbeispiel beschreibt die Druckschrift ein PV-Modul, bei dem Kontaktflächen verschiedener Zellanordnungen nicht in einem gemeinsamen Anschlussbereich an der Rückseite des PV-Moduls positioniert sind, sondern an mehreren, unterschiedlichen Positionen. **In** dem Fall ist jeder der Anschlussbereiche mit einer Dose abgedeckt, die eine Bypass-Diode aufnimmt. Zumindest zwei der Dosen fungieren wie zuvor beschrieben als Anschlussdose, indem ein Anschlusskabel zum externen Anschluss des PV-Moduls zu diesen Dosen führt und innerhalb der Dose mit einer der Zellanordnungen verbunden ist. **In** einem weiteren Ausführungsbeispiel ist beschrieben, dass die Bypass-Dioden auch in das PV-Modul, konkret in den Lagenstapel des PV-Moduls integriert sein können.

Verschattungen einzelner Zellanordnungen bei gleichzeitig hoher Sonneneinstrahlung auf benachbarte Zellanordnungen kann zu ungünstigen Betriebssituationen für die zugeordneten Bypass-Dioden führen, wodurch hohe Ströme und hohe Temperaturen auftreten. Derartige Betriebssituationen, aber auch Alterungsprozesse können zu einem Defekt einer Bypass-Diode führen. Solange eine Bypass-Diode nicht in den Lagenstapel eines PV-Moduls integriert ist, könnte sie grundsätzlich zwar ausgetauscht werden - Anwender und teilweise auch Monteure von PV-Modulen verfügen üblicherweise jedoch nicht über die dafür notwendige Kenntnisse und Werkzeuge.

Aus der Druckschrift DE 10 2015 111 768 A1 ist eine Anschlussanordnung für ein solches PV-Modul bekannt, bei der eine Steckaufnahme an einer Anschlussdose angeordnet ist, in die eine Bypass-Diode mit einem entsprechenden Stecker eingesteckt werden kann. Auf diese Weise kann die Bypass-Diode vorteilhaft zur Überprüfung ausgebaut werden und bei einem Defekt einfach ausgetauschet werden. Die Druckschrift DE 10 2015 218 526 A1 beschreibt eine Anschlussanordnung für ein PV-Modul mit einer Steckaufnahme, in die ein Anschlussstecker eingeschoben werden kann. Dabei ist eine Bypass-Diode austauschbar in dem Anschlussstecker angeodnet, wodurch sich ebenfalls der Vorteil ergibt, dass die Bypass-Diode einfach überprüft und ggf. ausgetauscht werden kann. Bei den beiden Systemen sind jedoch entsprechend ausgestaltete Anschlussdosen bzw. Steckverbinder erforderlich.

Es ist eine Aufgabe der vorliegenden Erfindung, eine Anschlussanordnung für ein PV-Modul und ein PV-Modul mit einer Anschlussanordnung zu schaffen, bei denen Probleme aufgrund von defekten Bypass-Dioden auf einfache Weise auch von nicht fachkundigen Personen behoben werden können, ohne dass speziell ausgebildete Anschlussdosen mit ggf. speziellen Anschlusssteckern benutzt werden müssen.

Diese Aufgabe wird gelöst durch eine Anschlussanordnung für ein PV-Modul bzw. ein PV-Modul mit einer derartigen Anschlussanordnung mit den Merkmalen des unabhängigen Anspruchs 1. Vorteilhafte Ausgestaltungen und Weiterbildungen sind Gegenstand der abhängigen Ansprüche.

Eine erfindungsgemäße Anschlussanordnung der eingangs genannten Art zeichnet sich dadurch aus, dass an die mindestens eine Anschlussdose mindestens ein Verbindungskabel angeschlossen ist, das zu einer weiteren Anschlussdose des Photovoltaikmoduls führt, wobei ein Steckhalter in das mindestens eine Verbindungskabel eingeschleift ist und wobei der Steckhalter die mindestens eine Steckaufnahme aufweist, in die die mindestens eine Bypass-Diode eingesteckt ist.

Die Steckaufnahme bietet zusammen mit der einsteckbaren Bypass-Diode eine einfache Möglichkeit, die Bypass-Diode auszutauschen, wenn sie aufgrund zum Beispiel einer thermischen und/oder elektrischen Überlastsituation funktionsuntüchtig geworden ist. Der Austausch kann aufgrund des einfachen Steckvorgangs auch von ungeübtem Personal vorgenommen werden. Zudem besteht die Möglichkeit, eine Bypass-Diode zu entnehmen und leicht auf ihre Funktionstüchtigkeit zu überprüfen, was bei einer in die Anschlussanordnung eingebauten Bypass-Diode nur mit aufwändigeren Meßverfahren möglich ist. Weiter ermöglicht die Steckbarkeit der Bypass-Diode eine flexible Ausstattung bzw. Nachrüstung der Anschlussanordnung mit Bypass-Dioden unterschiedlicher Qualitätsstufen. Zum Beispiel können herstellerseitig zunächst vorgesehene Bypass-Dioden aus Silizium durch aktiv geschaltete Bypass-Dioden auf Basis von MOSFET-Transistoren ausgetauscht werden, um Verluste während einer Verschattungssituation zu minimieren.

In einer vorteilhaften Ausgestaltung weist die Anschlussanordnung mindestens eine Anschlussdose auf. An die Anschlussdose kann ein Anschlusskabel für das Photovoltaikmodul angeschlossen sein. Die Anschlussdose kann dabei ein Kontaktelement aufweisen, das mit Kontakten des Photovoltaikmoduls verbindbar ist. Die Kontakte des PV-Moduls können beispielsweise freigelegte Kontaktstreifen auf der Rückseite des PV-Moduls sein. In dem Fall wird das Kontaktelement z.B. auf den Kontaktstreifen gelötet oder geschweißt, z.B. durch eine Punktschweißung. Auch ein Federkontakt, insbesondere ein Doppelfederkontakt, kann eingesetzt werden. Die Kontakte des PV-Moduls können auch (hervorstehende) Anschlusskontakte sein, die bereits auf freigelegte Kontaktstreifen aufgebracht sind. In dem Fall kann das Kontaktelement der Anschlussdose z.B. ein Tulpenkontakt oder ein sonstiger Steckkontakt sein. Auch ein (hervorstehende) Anschlusskontakt kann über einen Federkontakt oder einen Schweiß- oder Lötkontakt kontaktiert werden.

In einer weiteren bevorzugten Ausgestaltung kann die Anschlussdose einen isolationsdurchdringenden Kontakt zur Verbindung mit dem Anschlusskabel und/oder dem Verbindungskabel aufweisen. Eine Verbindung zu den Kabeln kann so einfach und platzsparend hergestellt werden. In alternativen Ausgestaltungen kann eine Verbindung auch durch einen Crimp-, Löt-, Schweiß- oder Verstemmvorgang mit einem dann jeweils abisolierten Kabelende hergestellt werden.

In einer Ausgestaltung kann dabei die mindestens eine Anschlussdose ebenfalls mindestens eine Steckaufnahme aufweisen, in die eine Bypass-Diode eingesteckt ist. Falls mehrere Anschlussdosen vorhanden sind, kann jede z.B. eine Steckaufnahme aufnehmen. Es können auch mehrere Steckaufnahmen für mehere Bypass-Dioden bei einer Anschlussdose vorgesehen sein, ggf. auch für alle vorhandenen Bypass-Dioden, insbesondere wenn nur eine Anschlussdose am PV-Modul vorhanden ist. Bevorzugzt liegt dabei zumindest ein Teil der Oberfläche der Bypass-Diode außerhalb der Anschlussdose. Die Bypass-Diode ist dadurch gut zugänglich und kann gestauscht werden, ohne dass die Anschlussdose geöffnet werden muss. Zudem hat die zumindest teilweise außerhalb gelagerte Bypass-Diode den Vorteil, das eine direkte Wärmeeinleitung in das PV-Modul vermieden oder zumindest reduziert wird. Dadurch wird eine Verschlechterung der Leistung des PV-Moduls durch einen thermischen Eintrag der Bypass-Diode verhindert bzw. verringert.

In einer weiteren vorteilhaften Ausgestaltung der Anschlussanordnung ist die mindestens eine Bypass-Diode in einem Gehäuse aufgenommen, aus dem die Steckkontakte herausragen. Das bevorzugt aus einem isolierenden Material geformte Gehäuse dient als Griffbereich, um die Bypass-Diode gefahrlos greiffen und in die Steckaufnahme einstecken bzw. aus dieser entnehmen zu können. Über das Gehäuse kann auch eine mechanische Kodierung vorgenommen werden, so dass die Bypass-Diode nur in einer korrekten Polarität eingesetzt werden kann. Schließlich ermöglicht das Gehäuse eine gute Abgabe von Wärme, die in der Bypass-Diode als Verlustwärme anfällt, an die Umgebung, da das Gehäuse eine größere Oberfläche als die Bypass-Diode selbst aufweist. Dieses gilt insbesondere, wenn die mindestens eine Bypass-Diode vorteilhaft in dem Gehäuse von einer gut wärmeleitenden Vergussmasse, z.B. einer Kunststoffmasse, umgeben ist.

**In** einer weiteren vorteilhaften Ausgestaltung der Anschlussanordnung ist parallel zu der mindestens einen Bypass-Diode eine Leuchtdiode geschaltet ist. Bei defekter Bypass-Diode führt ein Spannungsabfall über der Bypass-Diode zu einem Aufleuchten der Leuchtdiode, wodurch der Defekt der Bypass-Diode signalisiert wird.

Die Leuchtdiode kann dabei zusammen mit der Bypass-Diode angeordnet sein, z.B. in einem gemeinsamen Gehäuse, das durchsichtig oder teilweise durchsichtig sein kann, sodass ein von der Leuchtdiode signalisierter Defekt von außen gut erkennbar ist. Die Bypass-Diode kann alternativ auch mit einem durchsichtigen Werkstoff umspritzt sein. Es ist alternativ auch möglich, die Leuchtdiode im Bereich der Steckaufnahme anzuordnen.

Bei einem erfindungsgemäßen PV-Modul sind Bypass-Dioden aufgrund der Verwendung einer derartige Anschlussanordnung leicht austauchbar. Es ergeben sich die im Zusammenhang mit der Anschlussanordnung genannten Vorteile.

Die Erfindung wird nachfolgend anhand eines Ausführungsbeispiels mithilfe von Figuren näher erläutert. Die Figuren zeigen:
- Figur 1a: eine isometrische Darstellung eines PV-Moduls mit Blick auf seine Rückseite;
- Figur 1b: eine Detailansicht eines Teils einer Anschlussanordnung des PV-Moduls der Figur 1a;
- Figur 1c: eine Detailansicht einer Diodenanordnung des PV-Moduls der Figur 1a;
- Figur 2: eine Detailansicht eines Teils einer Anschlussanordnung des weiteren Ausführungsbeispiels eines PV-Moduls;
- Figur 3a, b: jeweils eine isometrische Ansicht einer Diodeneinheit zur Verwendung mit einem PV-Modul; und
- Figur 4a, b: jeweils eine isometrische Ansicht einer Diodeneinheit ohne Gehäuse.

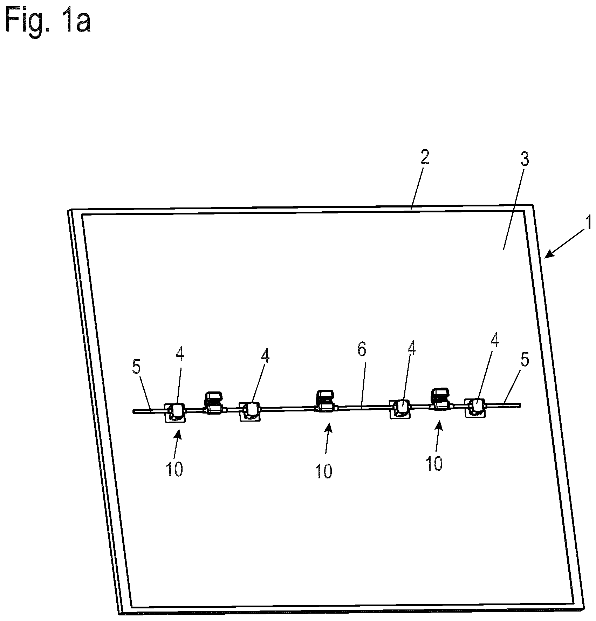

**In** Figur 1a ist zunächst ein PV-Modul 1 in einer isometrischen Darstellung wiedergegeben. Das PV-Modul 1 weist einen Rahmen 2 auf sowie die eigentliche Modulstruktur, die im Rahmen dieser Anmeldung auch als Schichtenaufbau oder Schichtenstapel bezeichnet wird. Von dieser Modulstruktur ist in der Darstellung der Figur 1a nur eine Rückseite 3 zu erkennen.

Bei dem PV-Modul 1 umfasst die Modulstruktur eine oder mehrere Zellanordnungen - hier konkret drei - die jeweils eine Mehrzahl von hier nicht einzeln erkennbaren PV-Zellen aufweisen, die an der Rückseite 3 an ihren Elektroden über z. B. Leiterbahnen miteinander verbunden sind. Die Rückseite 3 ist mit einer isolierenden Schicht abgedeckt, wobei diese isolierende Schicht an ausgewählten Stellen unterbrochen ist, um die Elektroden oder die sie verbindenden Leiterbahnen freizulegen und eine Kontaktierung zu ermöglichen. Alternativ können auch Anschlussfahnen oder Anschlusskontakte vorhanden sein, die mit den Elektroden oder den Leiterbahnen verbunden sind und die aus der isolierenden Schicht hervorstehen.

Bei dem in Figur 1a gezeigten Ausführungsbeispiel wird das PV-Modul 1 an vier Stellen kontaktiert. Über den Kontaktstellen ist jeweils eine Anschlussdose 4 montiert, bevorzugt aufgeklebt. Jeweils zwei nebeneinander liegende Kontaktstellen bzw. Anschlussdosen 4 sind einer Zellanordnung des PV-Moduls zu geordnet. Eine erste Zellanordnung ist beispielsweise über die beiden linken der Anschlussdosen 4 kontaktierbar, eine zweite Zellanordnung über die beiden mittleren der Anschlussdosen 4 und eine dritte Zellanordnung über die beiden rechten der Anschlussdosen 4. Es wird angemerkt, dass die Anzahl von hier drei miteinander serienverschalteten Zellanordnungen in dem dargestellten Ausführungsbeispiel rein beispielhaft ist. Die im Rahmen dieser Anmeldung vorgestellte Anschlussanordnung kann für jede beliebige Anzahl von miteinander serienverschalteten Zellanordnungen eingesetzt werden. Die einzelnen Zellanordnungen selbst weisen i. d. R. eine Mehrzahl von wiederum miteinander serien- und/oder parallel verschalteten Zellen auf.

Von den äußeren beiden der Anschlussdosen 4 führt jeweils ein Anschlusskabel 5 nach außen weg. Dieses Anschlusskabel 5 ist in den Figuren verkürzt dargestellt. **In** einer Umsetzung ist dieses Anschlusskabel 5 länger ausgebildet und weist an seinem Ende jeweils einen Steckverbinder auf, mit dem eine Verbindung zu einem benachbarten Modul oder einer Modulanschlussbox o.ä. hergestellt werden kann.

Zwischen jeweils zwei der Anschlussdosen 4 ist ein Verbindungskabel 6 angeordnet, in das eine Diodenanordnung 10 eingeschleift ist. Die Diodenanordnung 10 ist in der Figur 1a nur schematisch gezeigt. Sie umfasst eine hier nicht sichtbare gesteckte Bypass-Diode, die mit jeweils ihrer Anode bzw. Kathode die beiden Kabelabschnitte des Verbindungskabels 6 kontaktiert. Im vorliegenden Fall sind somit drei Bypass-Dioden jeweils antiparallel zu jeder der drei Zellanordnungen des PV-Moduls 1 geschaltet.

Die Anschlussanordnung kann bevorzugt vorkonfektioniert und vormontiert sein, so dass sie bei der Endmontage des PV-Moduls 1 nur auf Anschlusskontakte des PV-Moduls 1 aufgesetzt werden braucht. Bevorzugt wird dabei ein adhäsives Dichtungsmittel verwendet, mit dem die Anschlussdosen 4 auf die Rückseite 3 des PV-Moduls 1 abdichtend aufgeklebt werden.

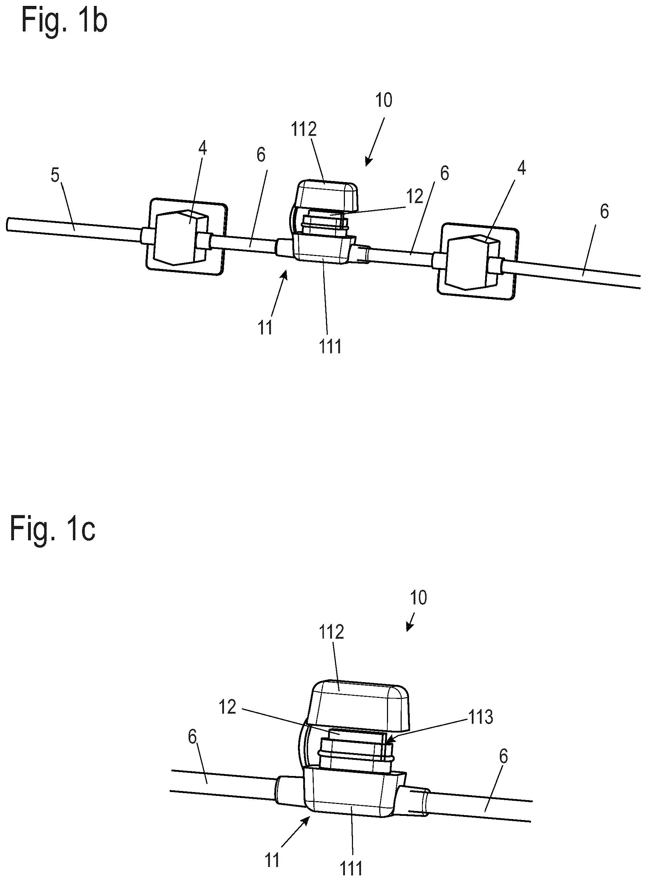

Zum Anschluss der Anschlusskabel 5 bzw. Verbindungskabel 6 innerhalb der Anschlussdosen 4 können zum Beispiel isolationsdurchdringende Kontakte verwendet werden. Zudem kann das Anschlusskabel 5 einstückig mit dem entsprechenden Abschnitt des Verbindungskabels 6 ausgebildet sein. Es handelt sich dann beim Anschlusskabel 5 und diesem Abschnitt des Verbindungskabels 6 um ein durchgehendes Kabelstück. Gleiches gilt für die beiden Abschnitte der Verbindungskabel 6 bei den in der Figur 1 a dargestellten mittleren beiden Anschlussdosen 4.

In der Figur 1b ist ein Teil der Anschlussanordnung des PV-Moduls 1 aus Figur 1a detaillierter in einer isometrischen Ansicht gezeigt. Hier ist ersichtlich, dass die Diodenanordnung 10 einen Steckhalter 11 umfasst, in den die Bypass-Diode eingesteckt werden kann. Der Steckhalter 11 ist in Figur 1c nochmals vergrößert wiedergegeben.

Der Steckhalter 11 umfasst einen Stecksockel 111, in den die Bypass-Diode in eine Steckaufnahme 113 eingesteckt werden kann. Mit dem Stecksockel 111 ist über einen flexiblen Steg unverlierbar eine Dichtungskappe 112 verbunden, die auf den Steckhalter 11 mit der eingesteckten Bypass-Diode aufgesetzt werden kann und die Steckaufnahme 113 abdichtet. In den Figuren 1b und 1c nicht sichtbar sind im Stecksockel 111 Kontakte angeordnet, die mit den Verbindungskabeln 6 gekoppelt sind und die eingesteckte Bypass-Diode kontaktieren. Die Steckaufnahme 113 und die eingesteckte Bypass-Diode können so geformt sein, dass die Bypass-Diode nur in einer möglichen Orientierung eingesteckt werden kann, um die richtige Polarität der eingesteckten Bypass-Diode sicherzustellen.

Der Steckhalter 11 bzw. dessen Steckaufnahme 123 bietet zusammen mit der einsteckbaren Bypass-Diode eine einfache Möglichkeit, die Bypass-Diode auszutauschen, wenn sie aufgrund zum Beispiel einer thermischen und/oder elektrischen Überlastsituation funktionsuntüchtig geworden ist. Der Austausch kann aufgrund des einfachen Steckvorgangs auch von ungeübtem Personal vorgenommen werden. Zudem besteht die Möglichkeit, eine Bypass-Diode zu entnehmen und leicht auf ihre Funktionstüchtigkeit zu überprüfen, was bei einer in die Anschlussanordnung eingebauten Bypass-Diode nur mit aufwändigeren Meßverfahren möglich ist. Weiter ermöglicht die Steckbarkeit der Bypass-Diode eine flexible Ausstattung bzw. Nachrüstung der Anschlussanordnung mit Bypass-Dioden unterschiedlicher Qualitätsstufen. Zum Beispiel können herstellerseitig zunächst vorgesehene Bypass-Dioden aus Silizium durch aktiv geschaltete Bypass-Dioden auf Basis von MOSFET-Transistoren ausgetauscht werden, um Verluste während einer Verschattungssituation zu minimieren.

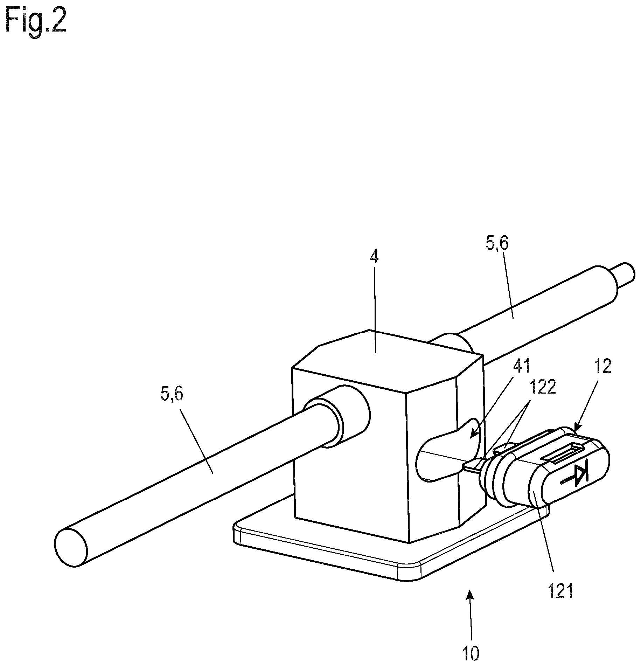

Figur 2 zeigt einen Teil einer Anschlussanordnung für ein hier nicht weiter dargestelltes PV-Modul in einem weiteren Ausführungsbeispiel. Die Anschlussanordnung weist wiederum eine Anschlussdose 4 auf, die auf der Rückseite des PV-Moduls montiert ist. Zu der Anschlussdose 4 führen zwei Kabel, die Anschlusskabel 5 und/oder Verbindungskabel 6 sein können.

Bei diesem Ausführungsbeispiel ist in der Anschlussdose 4 eine Steckaufnahme 41 als Teil einer Diodenanordnung 10 ausgebildet. Die Steckaufnahme 41 entspricht der Steckaufnahme 113 des Steckhalter 11 indem eine Diodeneinheit 12 mit einer Bypass-Diode eingesteckt werden kann. Die Diodeneinheit 12 ist beim Beispiel der Figur 2 separat von der Anschlussdose 4 dargestellt, also beispielsweise in einem Zustand kurz vor dem Einstecken in die Steckaufnahme 41.

Die Anschlussdose 4 kann über einem Kontakt des PV-Moduls positioniert sein, so dass innerhalb der Anschlussdose 4 der Kontakt des PV-Moduls mit der Bypass-Diode und auch mit den Anschlusskabeln 5 bzw. Verbindungskabeln 6 verbunden ist. Alternativ kann die gezeigte Anschlussdose 4 auch lediglich eine Verbindung zwischen der Bypass-Diode und den gezeigten Kabeln herstellen (die in dem Fall dann ausschließlich Verbindungskabel 6 sind). Die Anschlussdose 4 entspricht dann im Prinzip dem Steckhalter 11 des vorherigen Ausführungsbeispiels mit dem Unterschied, dass die Anschlussdose 4 auf der Rückseite des PV-Moduls montiert ist und nicht von den Verbindungskabeln 6 getragen wird.

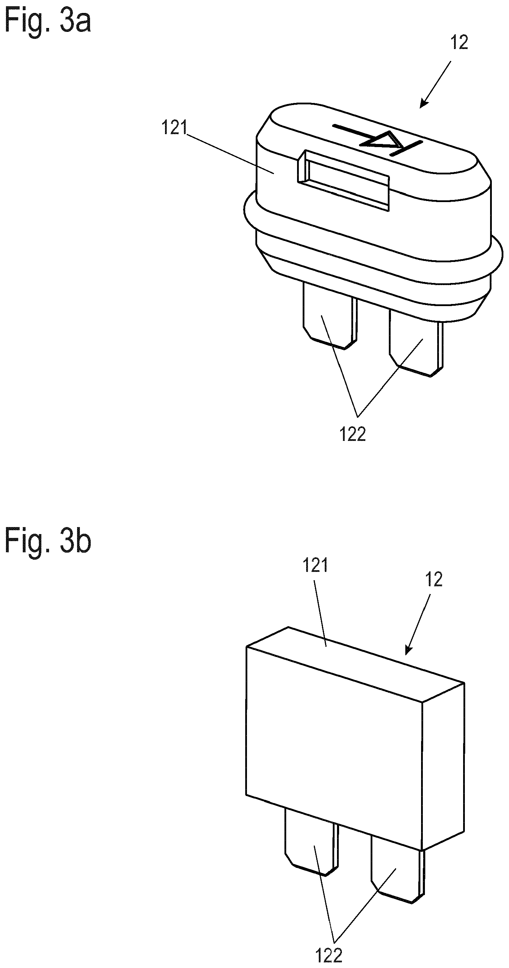

Bei der Diodeneinheit 12 ist die Bypass-Diode in einem Gehäuse 121 angeordnet und ist innerhalb des Gehäuses 121 mit Steckkontakten 122 verbunden, die aus dem Gehäuse 121 herausragen. Die in Figur 2 gezeigte Diodeneinheit 12 ist in Figur 3a auch nochmals separat detaillierter dargestellt. Figur 3b zeigt ebenfalls eine Diodeneinheit 12 mit einem Gehäuse 121 und Steckkontakten 122, das sich von dem in den Figuren 2 und 3a gezeigten Beispiel durch die Form seines Gehäuses 121 unterscheidet.

Das aus einem isolierenden Material geformte Gehäuse 121 dient als Griffbereich, an dem die Diodeneinheit 12 gefahrlos gegriffen und in die Steckaufnahme 41 bzw. 113 eingesetzt bzw. aus dieser heraus gezogen werden kann. Gegenkontakte, die in der Anschlussdose 4 bzw. dem Stecksockel 111 des Steckhalters 11 ausgebildet sind, und mit denen die Steckkontakte 122 kontaktieren, sind aufgrund der Höhe des Gehäuses 121 so weit in einem Schacht der Steckaufnahme 41, 113 vertieft, dass auch hier eine Berührung ausgeschlossen ist.

Bei dem in den Figuren 2 und 3a gezeigten Gehäuse 121 sind vorteilhaft seitlich Vertiefungen eingebracht, die ein Herausziehen der Diodeneinheit 12 aus der Steckaufnahme 41 bzw. 113 ermöglichen. Gegebenenfalls kann hierzu ein zangen- bzw. pinzettenartiges Hilfswerkzeug eingesetzt werden. Im unteren, zu den Steckkontakten 122 weisenden Bereich des Gehäuses 121 ist zudem ein Wulst ausgebildet, der einer Abdichtung des Gehäuses 121 in einem Schacht der Steckaufnahme 41, 113 dient.

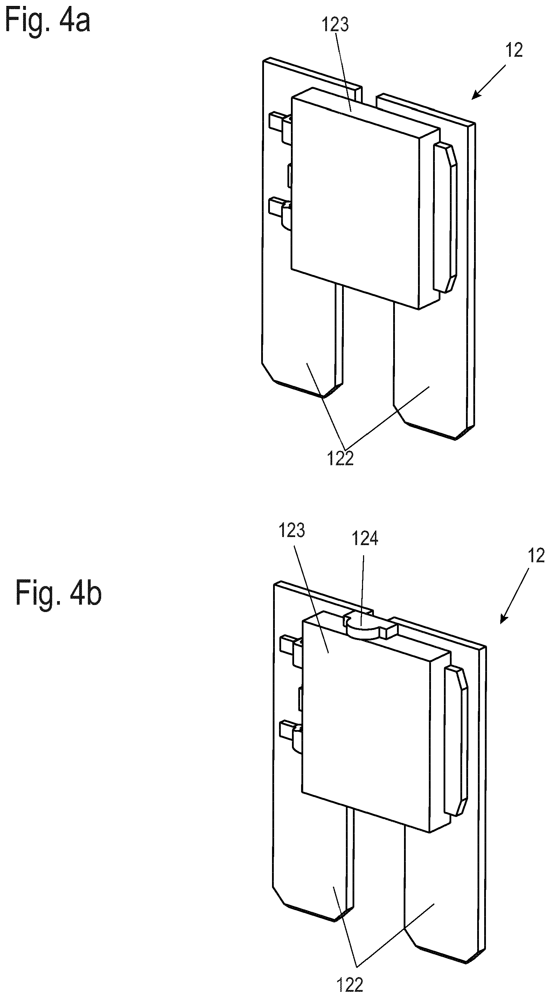

Ein möglicher innerer Aufbau der Diodeneinheiten 12 der Figuren 3a und 3b ist in den Figuren 4a und 4b gezeigt. In den Figuren 4a und 4b sind die Diodeneinheit 12 ohne das Gehäuse 121 wiedergegeben.

Die Diodeneinheit 12 weist jeweils eine Bypass-Diode 123 auf, die mit Anschlusselementen auf die Steckkontakte 122 aufgelötet ist. Beispielhaft sind die Bypass-Dioden 123 oberflächen-montierte Bauelemente. In alternativen Ausgestaltungen können stattdessen auch bedrahtete Bypass-Dioden eingesetzt werden, deren Anschlussdrähte mit den Steckkontakten 122 verbunden werden.

Die Einheit aus Bypass-Diode 123 und Steckkontakten 122 wird bevorzugt in das Gehäuse 121 eingesetzt und dort mit Vergussmasse vergossen. Es wird so eine gute Wärmeübertragung von der Bypass-Diode 123 auf das Gehäuse 121 erreicht, wobei von diesem die Wärme aufgrund der größeren Oberfläche des Gehäuses 121 verglichen mit der Oberfläche der Bypass-Diode 123 selbst gut an die Umgebung abgegeben werden kann. **In** einer Ausgestaltung der Diodeneinheit 12 bildet die Vergussmasse selbst das Gehäuse 121.

Die Diodeneinheit 12 des Beispiels der Figur 4b weist im Unterschied zum Beispiel der Figur 4a zusätzlich eine Leuchtdiode (LED) 124 auf, die parallel zur Bypass-Diode 123 geschaltet ist und ebenfalls mit den Steckkontakten 122 verbunden ist. Bevorzugt ist die LED 124 intern mit einem Vorwiderstand versehen oder es wird ein Vorwiderstand vorgeschaltet, so dass ein durch die LED 124 fließender Strom begrenzt ist. Bei funktionstüchtiger Bypass-Diode 123 ist bei einem Stromfluss durch die Diodeneinheit 12 ein Spannungsabfall an der Bypass-Diode 123 kleiner, als für ein Aufleuchten der LED 124 benötigt wird. Wenn dagegen die Bypass-Diode 123 dahingehend defekt ist, dass sie auch in Durchflussrichtung keinen Stromfluss aufnimmt, wird der Spannungsabfall an den Steckkontakten 122 so groß, dass die LED 124 aufleuchtet und damit den Defekt der Bypass-Diode 123 signalisiert. Um die LED 124 von außen einsehen zu können, ist das Gehäuse 121 zumindest in diesem Bereich transparent ausgebildet oder mit einem transparenten Sichtfenster versehen. Falls eine Vergussmasse verwendet wird, wird diese ebenso transparent gewählt oder bedeckt die **LED** 124 nicht.

**In** alternativen Ausgestaltungen der Anschlussanordnung kann vorgesehen sein, eine derartige Leuchtdiode nicht in der Diodeneinheit 12, sondern innerhalb des Steckhalters 11 oder der Anschlussdose 4, in die die Diodeneinheit 12 eingesteckt wird, zu positionieren.

### Bezugszeichen

- 1: Photovoltaik-Modul (PV-Modul)
- 2: Rahmen
- 3: Rückseite
- 4: Anschlussdose
- 41: Steckaufnahme
- 5: Anschlusskabel
- 6: Verbindungskabel
- 10: Diodenanordnung
- 11: Steckhalter
- 111: Stecksockel
- 112: Dichtungskappe
- 113: Steckaufnahme
- 12: Diodeneinheit
- 121: Gehäuse
- 122: Steckkontakt
- 123: Bypass-Diode
- 124: Leuchtdiode (LED)

## Patentansprüche

1. Anschlussanordnung für ein Photovoltaikmodul (1), das mindestens eine Zellanordnung aufweist, die extern an mindestens zwei Kontakten kontaktierbar ist, aufweisend mindestens eine Bypass-Diode (123), die extern von der mindestens einen Zellanordnung angordnet ist und parallel zu der mindestens einen Zellanordnung geschaltet ist, wobei die Anschlussanordnung mindestens eine Steckaufnahme (41, 113), in die die Bypass-Diode (123) mit Steckkontakten (122) eingesteckt ist, und mindestens eine Anschlussdose (4) aufweist, **dadurch gekennzeichnet, dass**
an die mindestens eine Anschlussdose (4) mindestens ein Verbindungskabel (6) angeschlossen ist, das zu einer weiteren Anschlussdose (4) des Photovoltaikmoduls (1) führt, wobei ein Steckhalter (11) in das mindestens eine Verbindungskabel (6) eingeschleift ist und wobei der Steckhalter (11) die mindestens eine Steckaufnahme (113) aufweist, in die die mindestens eine Bypass-Diode (123) eingesteckt ist.

2. Anschlussanordnung nach Anspruch 1, bei der an die mindestens eine Anschlussdose (4) mindestens ein Anschlusskabel (5) für das Photovoltaik-modul (1) angeschlossen ist.

3. Anschlussanordnung nach Anspruch 1 oder 2, bei der die mindestens eine Anschlussdose (4) jeweils ein Kontaktelement aufweist, das mit Kontakten des Photovoltaikmoduls (1) verbindbar ist.

4. Anschlussanordnung nach einem der Ansprüche 1 bis 3, bei der die Anschlussdose (4) einen isolationsdurchdringenden Kontakt zur Verbindung mit dem Anschlusskabel (5) und/oder dem Verbindungskabel (6) aufweist.

5. Anschlussanordnung nach einem der Ansprüche 1 bis 4, bei der die mindestens eine Bypass-Diode (123) in einem Gehäuse (121) aufgenommen ist, aus dem die Steckkontakte (122) herausragen.

6. Anschlussanordnung nach Anspruch 5, bei der die mindestens eine Bypass-Diode (123) in dem Gehäuse (121) von einer Vergussmasse umgeben ist.

7. Anschlussanordnung nach einem der Ansprüche 1 bis 6, bei der parallel zu der mindestens einen Bypass-Diode (123) eine Leuchtdiode (124) geschaltet ist.

8. Anschlussanordnung nach Anspruch 5 und 7, bei der die Leuchtdiode (124) ebenfalls in dem Gehäuse (121) angeordnet ist.

9. Photovoltaikmodul (1) mit mindestens einer Anschlussanordnung gemäß einem der Ansprüche 1 bis 8.

## Claims

1. A connection arrangement for a photovoltaic module (1) which has at least one cell arrangement which is externally contactable to at least two contacts, having at least one bypass diode (123), which is arranged externally of the at least one cell arrangement and connected in parallel to the at least one cell arrangement, wherein the connection arrangement comprises at least one plug receptacle (41, 113) into which the bypass diode (123) can be plugged in with plug contacts (122), and at least one connection box (4), **characterized in that** at least one connection cable (6) is connected to the at least one connection box (4), which leads to a further connection box (4) of the photovoltaic module (1), wherein a plug holder (11) is countersunk into the at least one connection cable (6) and wherein the plug holder (11) has the at least one plug receptacle (113) into which the at least one bypass diode (123) is plugged.

2. The connection arrangement according to Claim 1, in which at least one power cable (5) for the photovoltaic module (1) is connected to at the at least one connection box (4).

3. The connection arrangement according to Claim 1 or 2, in which the at least one connection box (4) in each case has a contact element that can be connected to contacts of the photovoltaic module (1).

4. The connection arrangement according to any one of Claims 1 to 3, in which the connection box (4) has an isolation-penetrating contact for connection to the power cable (5) and/or the connection cable (6).

5. The connection arrangement according to any one of Claims 1 to 4, in which the at least one bypass diode (123) is received in a housing (121), out of which the plug contacts (122) protrude.

6. The connection arrangement according to Claim 5, in which the at least one bypass diode (123) in the housing (121) is surrounded by a grouting compound.

7. The connection arrangement according to any one of Claims 1 to 6, in which a light-emitting diode (124) is connected in parallel to the at least one bypass diode (123).

8. The connection arrangement according to Claim 5 and 7, in which the light-emitting diode (124) is likewise arranged in the housing (121).

9. A photovoltaic module (1) with at least one connection arrangement according to any one of Claims 1 to 8.

## Revendications

1. Dispositif de raccordement pour un module photovoltaïque (1) qui comporte au moins une disposition de cellules pouvant être mise en contact avec l'extérieur sur au moins deux contacts, comportant au moins une diode de dérivation (123) disposée à l'extérieur de l'au moins une disposition de cellules et montée en parallèle avec l'au moins une disposition de cellules, lequel dispositif de raccordement comporte au moins un réceptacle d'enfichage (41, 113) dans lequel la diode de dérivation (123) est enfichée avec des contacts enfichables (122) et au moins une prise femelle de raccordement (4), **caractérisé en ce qu'**au moins un câble de connexion (6) menant à une autre prise femelle de raccordement (4) du module photovoltaïque (1) est raccordé sur l'au moins une prise femelle de raccordement (4), une fixation d'enfichage (11) étant bouclée dans l'au moins un câble de connexion (6) et la fixation d'enfichage (11) comportant l'au moins un réceptacle d'enfichage (113) dans lequel l'au moins une diode de dérivation (123) est enfichée.

2. Dispositif de raccordement selon la revendication 1, dans lequel au moins un câble de raccordement (5) pour le module photovoltaïque (1) est raccordé sur l'au moins une prise femelle de raccordement (4).

3. Dispositif de raccordement selon la revendication 1 ou 2, dans lequel l'au moins une prise femelle de raccordement (4) comporte un élément de contact respectif qui peut être connecté à des contacts du module photovoltaïques (1).

4. Dispositif de raccordement selon l'une des revendications 1 à 3, dans lequel la prise femelle de raccordement (4) comporte un contact traversant l'isolation pour la connexion au câble de raccordement (5) et/ou au câble de connexion (6).

5. Dispositif de raccordement selon l'une des revendications 1 à 4, dans lequel l'au moins une diode de dérivation (123) est logée dans un boîtier (121) duquel dépassent les contacts d'enfichage (122).

6. Dispositif de raccordement selon la revendication 5, dans lequel l'au moins une diode de dérivation (123) est entourée d'une masse d'enrobage dans le boîtier (121).

7. Dispositif de raccordement selon l'une des revendications 1 à 6, dans lequel une diode électroluminescente (124) est montée en parallèle avec l'au moins une diode de dérivation (123).

8. Dispositif de raccordement selon les revendications 5 et 7, dans lequel la diode électroluminescente (124) est également disposée dans le boîtier (121).

9. Module photovoltaïque (1) muni d'au moins un dispositif de raccordement selon l'une des revendications 1 à 8.
